# EUROPEAN PATENT APPLICATION

(11) **EP 4 451 051 A1**
(43) Date of publication of application: **23.10.2024**
(21) Application number: 22952332.9
(22) Date of filing: 27.07.2022
(51) Int. Cl.: G02F 1/1362

(54) **DISPLAY PANEL, DISPLAY APPARATUS, AND WEARABLE DEVICE**

(71) Applicant: Boe Technology Group Co., Ltd., Beijing 100015 (CN); Yunnan Invensight Optoelectronics Technology Co., Ltd., Kunming, Yunnan 650211 (CN)
(72) Inventor: PU, Chao, Beijing 100176 (CN); YANG, Shengji, Beijing 100176 (CN); CHEN, Xiaochuan, Beijing 100176 (CN); HUANG, Kuanta, Beijing 100176 (CN); LU, Pengcheng, Beijing 100176 (CN); YANG, Junyan, Beijing 100176 (CN); LI, Dachao, Beijing 100176 (CN); SHI, Rongrong, Beijing 100176 (CN); WEI, Junbo, Beijing 100176 (CN); BAI, Xiao, Beijing 100176 (CN); YANG, Bo, Beijing 100176 (CN); WU, Bin, Beijing 100176 (CN); ZHU, Shengdi, Beijing 100176 (CN); DING, Yanqiang, Beijing 100176 (CN); GUO, Zhicheng, Beijing 100176 (CN); ZHU, Yun, Beijing 100176 (CN)
(74) Representative: Isarpatent
(86) International application number: PCT/CN2022/108292
(87) International publication number: WO 2024/020869

(57) **Abstract**

The present application provides a display panel, a displaying device and a wearable device, which relates to the technical field of displaying. The display panel includes a displaying region and a peripheral region surrounding the displaying region, a region of the peripheral region other than the bonding sub-region includes a first testing-unit group and a second testing-unit group, and each of the first testing-unit group and the second testing-unit group includes one or more circuit testing units; the displaying region includes a first lateral side and a second lateral side that extend in a first direction and face each other, wherein the first direction refers to a direction from the bonding sub-region pointing to the displaying region; and a maximum distance from the first testing-unit group to the first lateral side in a direction perpendicular to the first direction is equal to a maximum distance from the second testing-unit group to the second lateral side in the direction perpendicular to the first direction. The display panel has a low difficulty in design and a good effect of displaying.

## Description

### TECHNICAL FIELD

The present application relates to the technical field of displaying, and particularly relates to a display panel, a displaying device and a wearable device.

### BACKGROUND

With the development of the technique of displaying, silicon-based organic light emitting diode (OLED) display products, because of their advantages such as a high resolution, a low power consumption, a small volume and a low weight, have been paid extensive attention to. They have a promising application prospect in high-resolution near-eye displaying industries such as wearable devices, industrial safety protection and medical treatment.

### SUMMARY

The embodiments of the present application employ the following technical solutions:

In the first aspect, an embodiment of the present application provides a display panel, wherein the display panel includes a displaying region and a peripheral region surrounding the displaying region, and the peripheral region includes a bonding sub-region located on one side of the displaying region;
a region of the peripheral region other than the bonding sub-region includes a first testing-unit group and a second testing-unit group, and each of the first testing-unit group and the second testing-unit group includes one or more circuit testing units;
the displaying region includes a first lateral side and a second lateral side that extend in a first direction and face each other, wherein the first direction refers to a direction from the bonding sub-region pointing to the displaying region; and
a maximum distance from the first testing-unit group to the first lateral side in a direction perpendicular to the first direction is equal to a maximum distance from the second testing-unit group to the second lateral side in the direction perpendicular to the first direction.

In some embodiments of the present application, a minimum distance from the first testing-unit group to the first lateral side in the direction perpendicular to the first direction is equal to a minimum distance from the second testing-unit group to the second lateral side in the direction perpendicular to the first direction.

In some embodiments of the present application, the region of the peripheral region other than the bonding sub-region includes a light shielding layer;
an inner contour of an orthographic projection of the light shielding layer on a substrate of the display panel contacts an edge of the displaying region; and
both of the first testing-unit group and the second testing-unit group are located on one side of the light shielding layer that is away from the displaying region, and orthographic projections of the first testing-unit group and the second testing-unit group on the substrate do not overlap with the orthographic projection of the light shielding layer on the substrate.

In some embodiments of the present application, the peripheral region includes a first peripheral sub-region, and the first peripheral sub-region is located on one side of the displaying region that is away from the bonding sub-region;
some of the circuit testing units in the first testing-unit group are located in the first peripheral sub-region, and the other of the circuit testing units in the first testing-unit group are located in a region of the peripheral region that is close to the first lateral side; and
some of the circuit testing units in the second testing-unit group are located in the first peripheral sub-region, and the other of the circuit testing units in the second testing-unit group are located in a region of the peripheral region that is close to the second lateral side.

In some embodiments of the present application, connecting lines between geometric centers of the circuit testing units in the first testing-unit group and connecting lines between geometric centers of the circuit testing units in the second testing-unit group individually form two intersecting line segments; or
the connecting lines between the geometric centers of the circuit testing units in the first testing-unit group and the connecting lines between the geometric centers of the circuit testing units in the second testing-unit group are arc lines.

In some embodiments of the present application, geometric centers of the circuit testing units in the first testing-unit group are located in a same line segment, and geometric centers of the circuit testing units in the second testing-unit group are located in a same line segment.

In some embodiments of the present application, all of the circuit testing units in the first testing-unit group are located in a region of the peripheral region that is close to the first lateral side, and all of the circuit testing units in the second testing-unit group are located in a region of the peripheral region that is close to the second lateral side.

In some embodiments of the present application, each of the first testing-unit group and the second testing-unit group includes a first end close to the bonding sub-region and a second end away from the bonding sub-region; and
a minimum distance between the first end and the displaying region in the direction perpendicular to the first direction is greater than or equal to a minimum distance between the second end and the displaying region in the direction perpendicular to the first direction.

In some embodiments of the present application, all of the circuit testing units in the first testing-unit group and the second testing-unit group are located in the first peripheral sub-region, and the circuit testing units in a same group are arranged in the direction perpendicular to the first direction; and
the first testing-unit group and the second testing-unit group are arranged in the first direction; or
the first testing-unit group and the second testing-unit group are arranged in the direction perpendicular to the first direction.

In some embodiments of the present application, the circuit testing units are arranged in mirror symmetry.

In some embodiments of the present application, in a direction parallel to a plane where the substrate is located, a minimum distance from the circuit testing units in the first testing-unit group and the second testing-unit group to the light shielding layer is less than a minimum distance from bonding terminals in the bonding sub-region to the light shielding layer.

In some embodiments of the present application, the display panel includes at least one third testing-unit group, the third testing-unit group includes a plurality of transistor testing units, and the third testing-unit group is located in the first peripheral sub-region; and
a distance between the transistor testing units and the light shielding layer is greater than or equal to a distance between the circuit testing units and the light shielding layer.

In some embodiments of the present application, the third testing-unit group is located on one side of all of the circuit testing units that is away from the displaying region, a gap is provided between the third testing-unit group and the light shielding layer, and both of the first testing-unit group and the second testing-unit group are located in the gap.

In some embodiments of the present application, the display panel includes two third testing-unit group, the two third testing-unit groups are arranged in the direction perpendicular to the first direction, the first peripheral sub-region includes an encoding pattern, and the encoding pattern is located between the two third testing-unit groups; and
a minimum distance between the encoding pattern and the light shielding layer is greater than or equal to a minimum distance between the transistor testing units and the light shielding layer.

In some embodiments of the present application, the peripheral region further includes a second peripheral sub-region, the second peripheral sub-region is located between the bonding sub-region and the displaying region, and the orthographic projection of the light shielding layer on the substrate falls within the region of the peripheral region other than the bonding sub-region; and
a distance in the first direction between a part of an outer contour of the light shielding layer that is located in the first peripheral sub-region and the edge of the displaying region is less than a distance in the first direction between a part of the outer contour of the light shielding layer that is located in the second peripheral sub-region and the edge of the displaying region.

In some embodiments of the present application, a shape of the orthographic projection of the light shielding layer on the substrate includes a rectangle having four rounded corners; and
a curvature radius of two of the rounded corners of the rectangle that are close to the bonding sub-region is greater than a curvature radius of two of the rounded corners of the rectangle that are close to the first peripheral sub-region.

In some embodiments of the present application, the display panel includes a cover plate, the cover plate covers the displaying region and part of the area of the light shielding layer, and an outer contour of an orthographic projection of the cover plate on the substrate falls within the orthographic projection of the light shielding layer on the substrate; and
four vertex angles of the outer contour of the orthographic projection of the cover plate on the substrate are located at the four rounded corners.

In some embodiments of the present application, an area of a region of a part of the light shielding layer that is located in the first peripheral sub-region that does not overlap with the cover plate is less than an area of a region of a part of the light shielding layer that is located in the second peripheral sub-region that does not overlap with the cover plate.

In some embodiments of the present application, a quantity of the circuit testing units is greater than a quantity of the bonding terminals.

In some embodiments of the present application, in a direction parallel to a plane where the substrate is located, a dimension of a region where the cover plate and the light shielding layer overlap in a direction from the displaying region pointing to the peripheral region is greater than a dimension of the circuit testing units in the first direction.

In some embodiments of the present application, an area of an orthographic-projection pattern of the circuit testing units on the substrate is less than or equal to an area of an orthographic-projection pattern of the bonding terminals on the substrate.

In some embodiments of the present application, the display panel further includes a detecting unit, the detecting unit includes a plurality of auxiliary sub-pixels, and the auxiliary sub-pixels are located in a region of the peripheral region that is close to the first lateral side, and/or the auxiliary sub-pixels are located in a region of the peripheral region that is close to the second lateral side;
a structure of the auxiliary sub-pixels is the same as a structure of the sub-pixels in the displaying region; and
the light shielding layer covers the detecting unit.

In some embodiments of the present application, the display panel further includes four marking patterns, the marking patterns are located on one side of the light shielding layer that is away from the substrate, and orthographic projections of the vertex angles of the cover plate on the substrate and orthographic projections of the marking patterns on the substrate at least partially overlap.

In the second aspect, an embodiment of the present application provides a displaying device, wherein the displaying device includes the display panel in the first aspect; and
the displaying device further includes a flexible circuit board and a driving chip; or
the display panel includes a displaying controlling unit, and the displaying device further includes a flexible circuit board.

In the third aspect, an embodiment of the present application provides a wearable device, wherein the wearable device includes two instances of the displaying device in the second aspect, and further includes two annular first supports, the displaying devices are fixed to the first supports, and each of the first supports covers a region of the peripheral region of the display panel that is not provided with the light shielding layer; and
the circuit testing units in one of the displaying devices and the circuit testing units in the other of the displaying devices are arranged in mirror symmetry.

In some embodiments of the present application, an orthographic projection of the first support on the substrate of the display panel overlaps with an orthographic projection of the light shielding layer on the substrate.

In some embodiments of the present application, an inner contour of the orthographic projection of the first support on the substrate is at least partially connected to an outer contour of an orthographic projection of the cover plate on the substrate.

In some embodiments of the present application, the wearable device further includes a second support, the second support is configured to be wearable, the second support includes a main-body part and two eyeglass temples, a driving board and the two first supports are fixed to the main-body part of the second support, and the driving board is electrically connected to the flexible circuit boards of the two displaying devices; and

the two display panels are arranged in mirror symmetry, geometric centers of the displaying regions of the two display panels and a geometric center of the main-body part of the second support are located in a same straight line, and the two flexible circuit boards are arranged in centrosymmetry with the geometric center of the second support as a symmetry point.

The above description is merely a summary of the technical solutions of the present application. In order to more clearly know the elements of the present application to enable the implementation according to the contents of the description, and in order to make the above and other purposes, features and advantages of the present application more apparent and understandable, the particular embodiments of the present application are provided below.

### BRIEF DESCRIPTION OF THE DRAWINGS

In order to more clearly illustrate the technical solutions of the embodiments of the present application or the related art, the figures that are required to describe the embodiments or the related art will be briefly described below. Apparently, the figures that are described below are merely embodiments of the present application, and a person skilled in the art can obtain other figures according to these figures without paying creative work.
FIG. 1 to FIG. 7 are schematic structural diagrams of seven types of the display panel according to the embodiments of the present application;
FIG. 8 to FIG. 11 are schematic diagrams of the intermediate structures of four types of the wearable device according to the embodiments of the present application;
FIG. 12 is a schematic structural diagram of first supports of a wearable device according to an embodiment of the present application;
FIG. 13 is a schematic structural diagram of a main-body part of a second support of a wearable device according to an embodiment of the present application;
FIG. 14 and FIG. 15 are two schematic structural diagrams of a wearable device according to the embodiments of the present application; and
FIG. 16 is a schematic diagram of an intermediate structure of a wearable device in the related art.

### DETAILED DESCRIPTION

The technical solutions of the embodiments of the present application will be clearly and completely described below with reference to the drawings of the embodiments of the present application. Apparently, the described embodiments are merely certain embodiments of the present application, rather than all of the embodiments. All of the other embodiments that a person skilled in the art obtains on the basis of the embodiments of the present application without paying creative work fall in the protection scope of the present application.

In the drawings, in order for clarity, the thicknesses of the regions and the layers might be exaggerated. In the drawings, the same reference numbers represent the same or similar components, and therefore the detailed description on them are omitted. Moreover, the drawings are merely schematic illustrations of the present application, and are not necessarily drawn to scale.

Unless stated otherwise in the context, throughout the description and the claims, the term "comprise" is interpreted as the meaning of opened containing, i.e., "including but not limited to". In the description of the present disclosure, the terms "one embodiment", "some embodiments", "exemplary embodiments", "example", "specific example" or "some examples" are intended to indicate that specific features, structures, materials or characteristics related to the embodiment or example are included in at least one embodiment or example of the present application. The illustrative indication of the above terms does not necessarily refer to the same embodiment or example. Moreover, the specific features, structures, materials or characteristics may be included in any one or more embodiments or examples in any suitable manner.

Furthermore, it should also be noted that, when the elements of the present application and the embodiments thereof are described, the articles "a", "an" and "the" are intended to indicate the existence of one or more elements. Unless stated otherwise, the meaning of "plurality of" is "two or more". The expressions "comprising", "including", "containing" and "having" are intended to be inclusive and indicate that other elements than the listed elements may exist. The terms "first", "second", "third" and so on are merely for the purpose of describing, and should not be construed as indicating or implying the degrees of importance and forming a sequence.

In the description, the "electric connection" includes the cases in which the component elements are connected together by an element having a certain electric function. The "element having a certain electric function" is merely required to be able to perform the receiving of an electric signal between the connected component elements, and is not particularly limited further. The examples of the "element having a certain electric function" do not only include electrodes and wires, but also include switching elements such as transistors, resistors, inductors, capacitors and other elements having various functions.

The polygons in the description are not the strictly defined polygons, and they may be an approximate triangle, rectangle, trapezoid, pentagon, hexagon and so on, may have some small deformations caused by tolerance, and may have chamfers, rounded corners, arc sides, deformations and so on.

In the description, "parallel" refers to the state in which the angle formed by two straight lines is not less than -10° and not greater than 10°, and thus also includes the state in which the angle is not less than -5° and not greater than 5°. Furthermore, "perpendicular" refers to the state in which the angle formed by two straight lines is not less than 80° and not greater than 100°, and thus also includes the state in which the angle is not less than 85° and not greater than 95°.

The exemplary embodiments will be described in further detail now with reference to the drawings.

With the development of the technique of displaying, silicon-based Organic Light Emitting Diode (OLED) display products, because of their characteristics such as a small volume and a high resolution, have been paid extensive attention to. Their back plate is fabricated by using a mature integrated-circuit Complementary Metal Oxide Semiconductor (CMOS) process, realizes the active addressing of the pixels, includes various circuits such as Timer Control Register (TCON) and Over Current Protection (OCP), and can realize light weighting.

The silicon-based OLED display products are extensively applied in near-eye displaying and Virtual Reality (referred to for short as VR) or Augmented Reality (referred to for short as AR), especially in AR/VR head-mounted displaying devices. Currently, the silicon-based OLED display products applied in AR/VR devices are required to have a high PPI (Pixels Per Inch, the unit of the pixel density), which has high requirements on the design of the pixel arrangement and the pixel area of the silicon-based OLED display products. Furthermore, in the highly integrated and miniaturized silicon-based OLED display products, in order to have a good effect of displaying while saving the design room, the designs in the related art have already been incapable of satisfying the demands.

Accordingly, the embodiments of the present application provide a newly designed display panel, to expand the usage scenes of the silicon-based display products, whereby they can be more extensively applied in high-resolution near-eye displaying industries such as wearable devices, industrial safety protection and medical treatment, and further can improve the effect of displaying and the usage experience of the user.

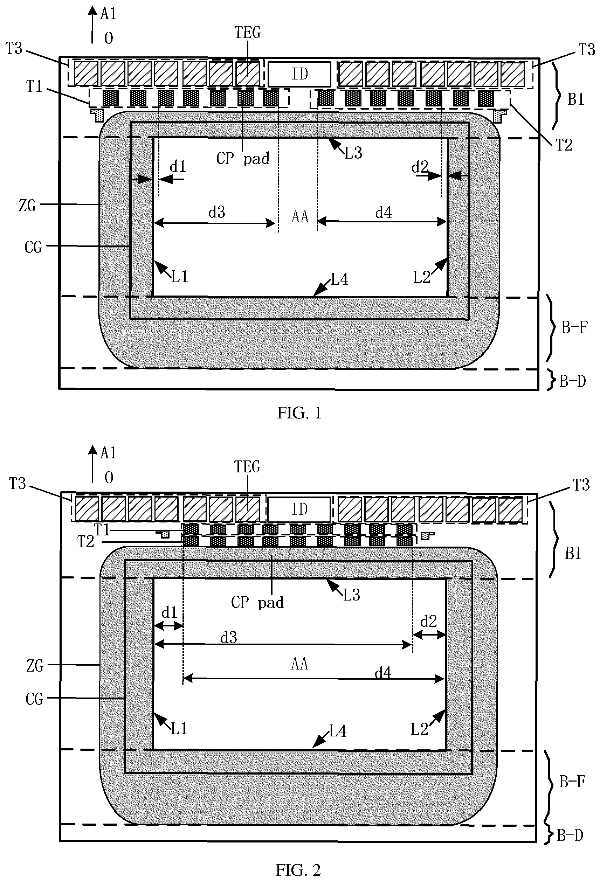

The embodiments of the present application employ the following technical solutions:
An embodiment of the present application provides a display panel. As shown in FIG. 1 to FIG. 7, the display panel includes a displaying region AA and a peripheral region surrounding the displaying region AA, and the peripheral region includes a bonding sub-region B-D located on one side of the displaying region.

The region of the peripheral region other than the bonding sub-region B-D includes a first testing-unit group T1 and a second testing-unit group T2, and each of the first testing-unit group T1 and the second testing-unit group T2 includes one or more circuit testing units CP pad. The displaying region AA includes a first lateral side L1 and a second lateral side L2 that extend in a first direction, for example, the direction OA1, and face each other, wherein the first direction, for example, the direction OA1, refers to the direction from the bonding sub-region B-D pointing to the displaying region AA.

The maximum distance d3 from the first testing-unit group T1 to the first lateral side L1 in the direction perpendicular to the first direction is equal to the maximum distance d3 from the second testing-unit group T2 to the second lateral side L2 in the direction perpendicular to the first direction.

The particular type of the display panel is not limited herein, and may be determined particularly according to practical situations.

As an example, the display panel may be an Organic Light Emitting Diode (OLED) display panel, and the OLED display panel includes an OLED display panel having a silicon substrate (Si Substrate) and an OLED display panel having a glass substrate.

As an example, the display panel may be a Micro-Organic Light Emitting Diode (Micro-OLED). Alternatively, the display panel may be a Mini-Organic Light Emitting Diode (Mini-OLED). The Micro-OLED display panel and the Mini-OLED display panel also include the two types of glass substrate and silicon substrate.

The silicon substrate may be a P-type monocrystalline-silicon substrate, and may also be an N-type monocrystalline-silicon substrate, which may be determined particularly according to practical products. It should be noted that the embodiments of the present application take the case as an example for the description in which the display panel is a display panel of a silicon substrate.

The planar graph of the displaying region AA is not limited herein.

As an example, the planar graph of the displaying region AA may be an exemplary rectangle shown in FIG. 1 to FIG. 7, and the planar graph of the displaying region AA may also be another polygon, for example, a pentagon and a hexagon, which is determined particularly according to usage scenes and usage demands.

The planar graph of the peripheral region may be annular. If the planar graph of the displaying region AA is different, the planar graph of the peripheral region is also different, and the planar graph of the peripheral region is decided according to the planar graph of the displaying region AA.

The planar graph refers to the pattern of the orthographic projection of the display panel on the substrate.

The bonding sub-region B-D refers to the region in the peripheral region that is used to be bonded to the driving chip (IC) and the flexible circuit board (FPC).

In some embodiments, in order to save the design space, and increase the resolution of the product, the relevant circuits and modules in the driving chip IC are integrated into the driving base plate of the display panel. In this case, the display panel may not be provided with the driving chip, and accordingly the bonding sub-region B-D refers to the region in the peripheral region that is used to be bonded to the flexible circuit board (FPC).

In some embodiments, in order to reduce the cost, if the display panel includes both of the driving chip (IC) and the flexible circuit board (FPC), the bonding sub-region B-D refers to the region in the peripheral region that is used to be bonded to the driving chip (IC) and the flexible circuit board (FPC) individually.

Each of the first testing-unit group T1 and the second testing-unit group T2 includes one or more circuit testing units CP pad. All of the embodiments of the present application take the case as an example for the description in which each of the first testing-unit group T1 and the second testing-unit group T2 includes a plurality of circuit testing units CP pad.

When each of the first testing-unit group T1 and the second testing-unit group T2 includes a plurality of circuit testing units CP pad, the particular quantities of the circuit testing units CP pad in each of the groups are not limited herein, and the quantities may be decided according to the design of the driving circuit in the driving base plate of the display panel.

The circuit testing units CP pad may be used to, after the fabrication of the driving base plate in the display panel is completed or the fabrication of the display panel is completed, test the overall electric performance of the driving circuit in the driving base plate, to check whether its driving circuit is abnormal, and, if it is abnormal, repair or regulate the abnormality according to circumstances. It should be noted that, after the display panel is fabricated into the displaying device and in the process of the user usage, the circuit testing units CP pad are not used.

The shape of the orthographic projection of the circuit testing unit CP pad on the substrate of the display panel is not limited herein. As an example, as shown in FIG. 1 to FIG. 7, the shape of the orthographic projection of the circuit testing unit CP pad on the substrate of the display panel may be a rectangle. Certainly, the shape of the orthographic projection of the circuit testing unit CP pad on the substrate of the display panel may also be a circle or another polygon than a rectangle, which may be determined particularly according to practical product designs.

The size of the circuit testing unit CP pad is not limited herein.

It is not limited herein whether the sizes of the circuit testing units CP pad in the same testing-unit group are equal. The drawings according to the embodiments of the present application illustrate by taking the case as an example in which the sizes of all of the circuit testing units CP pad are equal.

It is not limited herein whether the quantity of the circuit testing units CP pad in the first testing-unit group T1 and the quantity of the circuit testing units CP pad in the second testing-unit group T2 are equal.

In some embodiments, in order to simplify the design, it may be configured that the quantity of the circuit testing units CP pad in the first testing-unit group T1 and the quantity of the circuit testing units CP pad in the second testing-unit group T2 are equal.

The first lateral side L1 and the second lateral side L2 of the displaying region AA are two opposite lateral sides of the displaying region AA that extend in the first direction. The displaying region AA may further include a third lateral side L3 and a fourth lateral side L4, as shown in FIG. 1 to FIG. 7. Alternatively, the displaying region AA may also include a third lateral side, a fourth lateral side, a fifth lateral side and a sixth lateral side. The directions of extension of the other lateral sides than the first lateral side L1 and the second lateral side L2 are not limited herein.

It should be noted that, because the directions of extension of the first lateral side L1 and the second lateral side L2 of the displaying region AA are the same (i.e., parallel), the planar graph of the displaying region AA cannot be a triangle.

In an exemplary embodiment, the maximum distance d3 from the first testing-unit group T1 to the first lateral side L1 in the direction perpendicular to the first direction refers to, among the circuit testing units CP pad of the first testing-unit group T1, the distance between the circuit testing unit CP pad farthest from the first lateral side L1 in the direction perpendicular to the first direction and the first lateral side L1.

In an exemplary embodiment, the maximum distance d4 from the second testing-unit group T2 to the second lateral side L2 in the direction perpendicular to the first direction refers to, among the circuit testing units CP pad of the second testing-unit group T2, the distance between the circuit testing unit CP pad farthest from the second lateral side L2 in the direction perpendicular to the first direction and the second lateral side L2.

In the embodiments of the present application, by configuring that the maximum distance d3 from the first testing-unit group T1 to the first lateral side L1 in the direction perpendicular to the first direction and the maximum distance d4 from the second testing-unit group T2 to the second lateral side L2 in the direction perpendicular to the first direction are equal, the arrangement mode of the first testing-unit group T1 in the peripheral region and the arrangement mode of the second testing-unit group T2 in the peripheral region can be the same to the largest extent. In an aspect, that can, in the subsequent test on the overall electric performance of the driving circuit in the driving base plate, facilitate the circuit testing units CP pad to be electrically connected to the interfaces corresponding to the external testing devices, and reduce the probability of connection confusion or signal-transmission confusion, and can shorten the fabrication period of the product. In another aspect, that can enable the arrangement of the first testing-unit group T1 in the peripheral region and the arrangement of the second testing-unit group T2 in the peripheral region to be symmetrically distributed to the largest extent, to increase the regularity of their distribution, and reduce the difficulty in design.

In some embodiments of the present application, as shown in FIG. 1 to FIG. 7, the minimum distance d1 from the first testing-unit group T1 to the first lateral side L1 in the direction perpendicular to the first direction is equal to the minimum distance d2 from the second testing-unit group T2 to the second lateral side L2 in the direction perpendicular to the first direction.

The minimum distance d1 from the first testing-unit group T1 to the first lateral side L1 in the direction perpendicular to the first direction refers to, among the circuit testing units CP pad of the first testing-unit group T1, the distance between the circuit testing unit CP pad closest to the first lateral side L1 in the direction perpendicular to the first direction and the first lateral side L1.

The minimum distance d2 from the second testing-unit group T2 to the second lateral side L2 in the direction perpendicular to the first direction refers to, among the circuit testing units CP pad of the second testing-unit group T2, the distance between the circuit testing unit CP pad closest to the second lateral side L2 in the direction perpendicular to the first direction and the second lateral side L2.

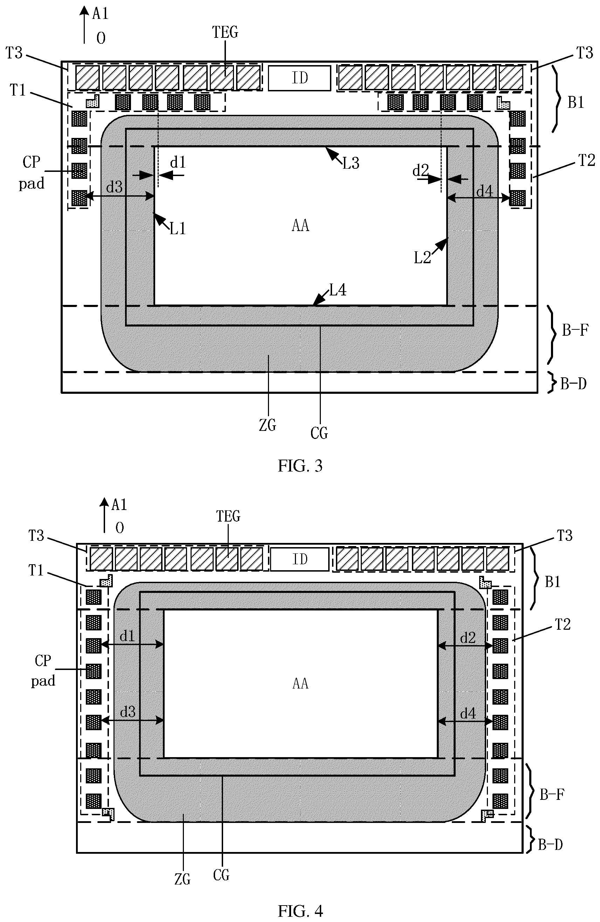

In some embodiments, as shown in FIG. 4, the minimum distance d1 from the first testing-unit group T1 to the first lateral side L1 in the direction perpendicular to the first direction and the maximum distance d3 from the first testing-unit group T1 to the first lateral side L1 in the direction perpendicular to the first direction are equal. The minimum distance d2 from the second testing-unit group T2 to the second lateral side L2 in the direction perpendicular to the first direction and the maximum distance d4 from the second testing-unit group T2 to the second lateral side L2 in the direction perpendicular to the first direction are equal.

As an example, as shown in FIG. 4, all of the minimum distance d1 from the first testing-unit group T1 to the first lateral side L1 in the direction perpendicular to the first direction, the minimum distance d2 from the second testing-unit group T2 to the second lateral side L2 in the direction perpendicular to the first direction, the maximum distance d3 from the first testing-unit group T1 to the first lateral side L1 in the direction perpendicular to the first direction, and the maximum distance d4 from the second testing-unit group T2 to the second lateral side L2 in the direction perpendicular to the first direction are equal.

In the embodiments of the present application, by configuring that the maximum distance d3 from the first testing-unit group T1 to the first lateral side L1 in the direction perpendicular to the first direction and the maximum distance d4 from the second testing-unit group T2 to the second lateral side L2 in the direction perpendicular to the first direction are equal, and the minimum distance d1 from the first testing-unit group T1 to the first lateral side L1 in the direction perpendicular to the first direction and the minimum distance d2 from the second testing-unit group T2 to the second lateral side L2 in the direction perpendicular to the first direction are equal, that can, in the subsequent test on the overall electric performance of the driving circuit in the driving base plate, further facilitate the circuit testing units CP pad to be electrically connected to the external testing devices, and reduce the probability of connection confusion. That also can enable the arrangement of the first testing-unit group T1 in the peripheral region and the arrangement of the second testing-unit group T2 in the peripheral region to be symmetrically distributed to the largest extent, to further increase the regularity of their distribution, and reduce the difficulty in design.

In some embodiments of the present application, as shown in FIG. 1 to FIG. 7, the region of the peripheral region other than the bonding sub-region B-D includes a light shielding layer ZG. The inner contour of the orthographic projection of the light shielding layer ZG on a substrate of the display panel contacts the edge of the displaying region AA.

Both of the first testing-unit group T1 and the second testing-unit group T2 are located on the side of the light shielding layer ZG that is away from the displaying region AA, and the orthographic projections on the substrate of the first testing-unit group T1 and the second testing-unit group T2 do not overlap with the orthographic projection of the light shielding layer ZG on the substrate.

In an exemplary embodiment, the light shielding layer ZG located in the peripheral region surrounds the displaying region AA. It can be understood that the shape of the projection of the light shielding layer ZG may be annular. The particular shape of the annular shape is not limited herein. As an example, the annular shape may include a circularly annular shape, an elliptically annular shape, a polygonally annular shape and so on.

Furthermore, the "contacting" described above refers to that the inner contour of the projection of the light shielding layer ZG is tangent to the outer contour of the projection of the displaying region AA, and the light shielding layer ZG does not cover the displaying region AA.

That both of the first testing-unit group T1 and the second testing-unit group T2 are located on the side of the light shielding layer ZG that is away from the displaying region AA refers to that both of the first testing-unit group T1 and the second testing-unit group T2 are located on the outer side of the light shielding layer ZG. The outer side refers to the region outside the outer contour of the light shielding layer ZG.

In the embodiments of the present application, the peripheral region, besides the first testing-unit group T1 and the second testing-unit group T2, may further be provided with other circuits and a plurality of traces, for example, cascade-arranged shift registers (GOA) and a light-emission controlling circuit (EOA).

In some embodiments, at least part of, for example, the shift registers (GOA), the light-emission controlling circuit (EOA) and the plurality of traces may be provided between the substrate of the display panel and the light shielding layer ZG. In other words, the light shielding layer ZG covers at least part of the shift registers (GOA), the light-emission controlling circuit (EOA) and the plurality of traces, to prevent the light reflection by the circuits and the traces from deteriorating the effect of displaying.

As an example, if the fabrication process conditions allow, the light shielding layer ZG covers as many circuits and traces located in the region in the peripheral region other than the bonding sub-region as possible.

In an exemplary embodiment, the material of the light shielding layer ZG includes an insulating material having the function of light shielding.

As an example, the light shielding layer ZG and a black-matrix layer BM may be fabricated by using the same material simultaneously in a one-step patterning process.

As an example, the light shielding layer ZG may include a plurality of sublayers. For example, the light shielding layer ZG may be obtained by arranging in stack a first sublayer fabricated by using a material the same as that of a red-color color-film pattern, a second sublayer fabricated by using a material the same as that of a green-color color-film pattern and a third sublayer fabricated by using a material the same as that of a blue-color color-film pattern. The order of the provision of the first sublayer, the second sublayer and the third sublayer is not limited herein. For example, the first sublayer, the second sublayer and the third sublayer may be sequentially provided in the direction further away from the substrate. As another example, the first sublayer, the third sublayer and the second sublayer may be sequentially provided in the direction further away from the substrate. As another example, the second sublayer, the first sublayer and the third sublayer may be sequentially provided in the direction further away from the substrate. Certainly, there may be other cases, which may be decided particularly according to the process order of the fabrication of the red-color color-film pattern, the green-color color-film pattern and the blue-color color-film pattern.

In the embodiments of the present application, by providing the light shielding layer ZG, as the light shielding layer ZG can block at least part of the circuits and the wirings in the peripheral region, to prevent their light reflection from deteriorating the effect of displaying, both of the first testing-unit group T1 and the second testing-unit group T2 are located on the side of the light shielding layer ZG that is away from the displaying region AA, and the orthographic projections of the first testing-unit group T1 and the second testing-unit group T2 on the substrate do not overlap with the orthographic projection of the light shielding layer ZG on the substrate. Accordingly, the light shielding layer ZG exposes the circuit testing units CP pad in the first testing-unit group T1 and the second testing-unit group T2, to facilitate the electric connection to the external testing devices, and reduce the probability of connection confusion.

In some embodiments of the present application, as shown in FIG. 1 to FIG. 7, the peripheral region includes a first peripheral sub-region B1, and the first peripheral sub-region B1 is located on the side of the displaying region AA that is away from the bonding sub-region B-D.

Taking the case as an example in which the planar graph of the displaying region AA of the display panel according to the embodiments of the present application is a rectangle, that the first peripheral sub-region B1 is located on the side of the displaying region AA that is away from the bonding sub-region B-D refers to that, because the first lateral side L1 and the second lateral side L2 are two opposite lateral sides, opposite third lateral side L3 and fourth lateral side L4 exist between the first lateral side L1 and the second lateral side L2, to form a closed pattern. The first peripheral sub-region B1 and the bonding sub-region B-D are located on the outer sides of the two opposite lateral sides of the displaying region AA. For example, the first peripheral sub-region B1 is located on the outer side of the third lateral side L3 of the displaying region AA, and the bonding sub-region B-D is located on the outer side of the fourth lateral side L4 of the displaying region AA.

As shown in FIG. 3, some of the circuit testing units CP pad in the first testing-unit group T1 are located in the first peripheral sub-region B1, and the other of the circuit testing units CP pad in the first testing-unit group T1 are located in the region of the peripheral region that is close to the first lateral side L1.

Some of the circuit testing units CP pad in the second testing-unit group T2 are located in the first peripheral sub-region B1, and the other of the circuit testing units CP pad in the second testing-unit group T2 are located in the region of the peripheral region that is close to the second lateral side L2.

In the embodiments of the present application, the description related to "part" and "other part" does not indicate that merely two parts are included, but a third part or a fourth part may further be included, which is decided particularly according to designs, and is explained herein.

In some embodiments, as shown in FIG. 3, the quantity of the circuit testing units CP pad located in the first peripheral sub-region B1 in the first testing-unit group T1 and the quantity of the circuit testing units CP pad located in the region of the peripheral region that is close to the first lateral side L1 in the first testing-unit group T1 are equal. The quantity of the circuit testing units CP pad located in the first peripheral sub-region B1 in the second testing-unit group T2 and the quantity of the circuit testing units CP pad located in the region of the peripheral region that is close to the second lateral side L2 in the second testing-unit group T2 are equal.

In some other embodiments, it may be configured that the quantity of the circuit testing units CP pad located in the first peripheral sub-region B1 in the first testing-unit group T1 is greater than the quantity of the circuit testing units CP pad located in the region of the peripheral region that is close to the first lateral side L1 in the first testing-unit group T1, and the quantity of the circuit testing units CP pad located in the first peripheral sub-region B1 in the second testing-unit group T2 is greater than the quantity of the circuit testing units CP pad located in the region of the peripheral region that is close to the second lateral side L2 in the second testing-unit group T2. Accordingly, a larger design room can be left in the left-side region of the displaying region AA (the region in the peripheral region that is close to the first lateral side L1) and the right-side region of the displaying region AA (the region in the peripheral region that is close to the second lateral side L2) for the arrangement of GOA circuits, EOA circuits and various types of signal lines. The signal lines may include power lines, ground lines, clock-signal lines and so on.

In some embodiments of the present application, the circuit testing units CP pad in the first testing-unit group T1 are arranged in an L shape, and the circuit testing units CP pad in the second testing-unit group T2 are arranged in an L shape.

In some embodiments, the connecting lines between the geometric centers of the circuit testing units CP pad in the first testing-unit group T1 may be two intersecting line segments. The angle of the included angle formed by the two intersecting line segments is not limited herein. As an example, the angle range of their included angle may be 0°-180°, for example, 90°, 85° and 80°.

The connecting lines between the geometric centers of the circuit testing units CP pad in the second testing-unit group T2 may be two intersecting line segments. The included angle formed by the two intersecting line segments is similar to the above-described included angle.

As an example, it may be configured that the included angle formed by the connecting lines between the geometric centers of the circuit testing units CP pad in the first testing-unit group T1 and the included angle formed by the connecting lines between the geometric centers of the circuit testing units CP pad in the second testing-unit group T2 are equal.

In some embodiments, all of the connecting lines between the geometric centers of the circuit testing units CP pad in the first testing-unit group T1 and the connecting lines between the geometric centers of the circuit testing units CP pad in the second testing-unit group T2 may be arc lines. The radians of the arc lines are not limited herein.

As an example, the arc lines formed by the connecting lines between the geometric centers of the circuit testing units CP pad in the first testing-unit group T1 and the arc lines formed by the connecting lines between the geometric centers of the circuit testing units CP pad in the second testing-unit group T2 may be distributed in mirror symmetry.

In an exemplary embodiment, as shown in FIG. 3, at the position between the circuit testing units CP pad located in the first peripheral sub-region B1 in the first testing-unit group T1 and the circuit testing units CP pad located in the region of the peripheral region that is close to the first lateral side L1 in the first testing-unit group T1, an island-like pattern used for alignment in the fabrication of the circuit testing units CP pad may be provided. At the position between the circuit testing units CP pad located in the first peripheral sub-region B1 in the second testing-unit group T2 and the circuit testing units CP pad located in the region of the peripheral region that is close to the second lateral side L2 in the second testing-unit group T2, an island-like pattern used for alignment marking may be provided.

Because the same testing-unit group is located in two different regions, by providing one island-like pattern used for alignment marking between the two regions, in an aspect, one island-like pattern can be omitted, to save the design room. In another aspect, that further facilitates to increase the alignment accuracy, and reduces the difficulty in the fabricating process.

It should be noted that, regarding the structure shown in FIG. 3, in the fabrication of the circuit testing units CP pad in practical applications, when the first testing-unit group T1 is using its corresponding island-like pattern, it may also utilize the island-like pattern of the second testing-unit group T2 as the alignment reference. Likewise, when the second testing-unit group T2 is using its corresponding island-like pattern, it may also utilize the island-like pattern of the first testing-unit group T1 as the alignment reference, to save the design room, and increase the alignment accuracy.

Certainly, the island-like pattern used for alignment marking may also be provided at the two ends of the same testing-unit group. It can be understood that, in this case, one testing-unit group is correspondingly provided with two island-like patterns used for alignment marking.

In some embodiments of the present application, as shown in FIG. 1, FIG. 2 and FIG. 4 to FIG. 6, the geometric centers of the circuit testing units CP pad in the first testing-unit group T1 are located in the same line segment, and the geometric centers of the circuit testing units CP pad in the second testing-unit group T2 are located in the same line segment.

It is not limited herein whether the connecting lines between the geometric centers of the circuit testing units CP pad in the first testing-unit group T1 and the connecting lines between the geometric centers of the circuit testing units CP pad in the second testing-unit group T2 are collinear, or are parallel, or intersect.

In some embodiments, as shown in FIG. 1, the connecting lines between the geometric centers of the circuit testing units CP pad in the first testing-unit group T1 and the connecting lines between the geometric centers of the circuit testing units CP pad in the second testing-unit group T2 are collinear.

In some other embodiments, as shown in FIG. 2 and FIG. 4, the connecting lines between the geometric centers of the circuit testing units CP pad in the first testing-unit group T1 and the connecting lines between the geometric centers of the circuit testing units CP pad in the second testing-unit group T2 are parallel.

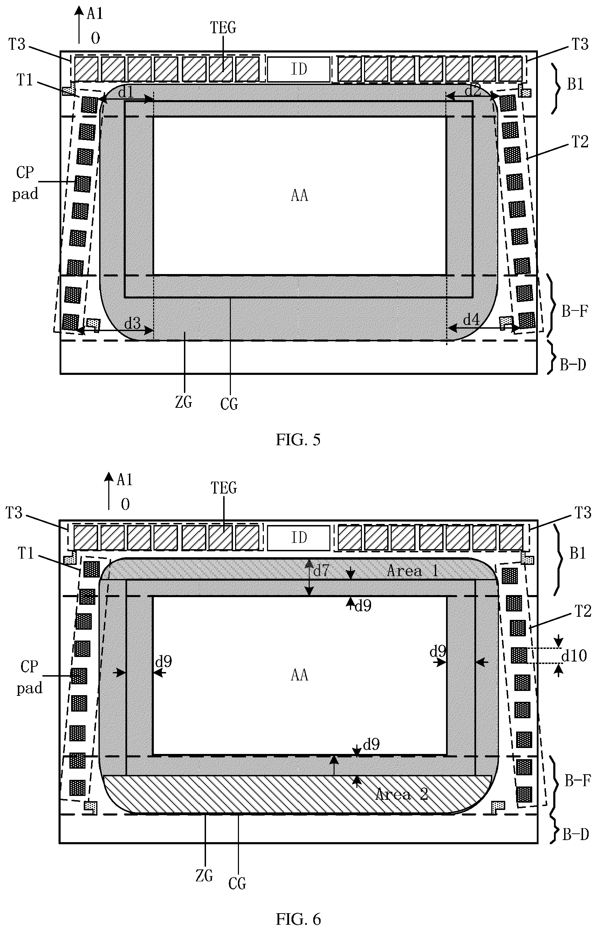

In some other embodiments, as shown in FIG. 5 and FIG. 6, the connecting lines between the geometric centers of the circuit testing units CP pad in the first testing-unit group T1 and the connecting lines between the geometric centers of the circuit testing units CP pad in the second testing-unit group T2 can intersect.

In some embodiments of the present application, as shown in FIG. 4, FIG. 5 and FIG. 6, all of the circuit testing units CP pad in the first testing-unit group T1 are located in the region of the peripheral region that is close to the first lateral side L1, and all of the circuit testing units CP pad in the second testing-unit group T2 are located in the region of the peripheral region that is close to the second lateral side L2.

In some embodiments of the present application, as shown in FIG. 4, FIG. 5 and FIG. 6, each of the first testing-unit group T1 and the second testing-unit group T2 includes a first end close to the bonding sub-region B-D and a second end away from the bonding sub-region B-D. The minimum distance between the first end and the displaying region AA in the direction perpendicular to the first direction (for example, the direction OA1) is greater than or equal to the minimum distance between the second end and the displaying region AA in the direction perpendicular to the first direction.

In some embodiments, as shown in FIG. 4, all of the minimum distances between the circuit testing units CP pad and the edge of the displaying region AA are equal.

In some other embodiments, as shown in FIG. 5 and FIG. 6, in the first direction (for example, the direction OA1), the minimum distances between the circuit testing units CP pad and the edge of the displaying region AA gradually decrease.

In some other embodiments, in the first direction (for example, the direction OA1), the minimum distances between the circuit testing units CP pad and the edge of the displaying region AA gradually increase.

In some embodiments of the present application, as shown in FIG. 5 and FIG. 6, the orthographic-projection pattern of the circuit testing unit CP pad on the substrate of the display panel includes a first edge, and the first edge is close to the first lateral side L1 of the displaying region AA, or the first edge is close to the second lateral side L2 of the displaying region AA.

As an example, as shown in FIG. 6, all of the first edges of the circuit testing units CP pad extend in the first direction (for example, the direction OA1). In this case, the directions of extension of the first edges of the circuit testing units CP pad in the same circuit-testing-unit-group are the same, and the first edges can be collinear.

As an example, as shown in FIG. 5, all of the directions of extension of the first edges of the circuit testing units CP pad intersect with the first direction (for example, the direction OA1). In this case, the first edges in the same circuit-testing-unit-group can intersect.

In practical applications, the positions of the provision of the circuit testing units CP pad that facilitate to save the room may be decided according to the arrangement of the circuits and the wirings provided in the region located on the first lateral side L1 of the peripheral region and the region located on the second lateral side L2 of the peripheral region.

In some embodiments of the present application, as shown in FIG. 1 and FIG. 2, all of the circuit testing units CP pad in the first testing-unit group T1 and the second testing-unit group T2 are located in the first peripheral sub-region B1, and the circuit testing units CP pad in the same of the groups are arranged in the direction perpendicular to the first direction (for example, the direction OA1).

As shown in FIG. 2, the first testing-unit group T1 and the second testing-unit group T2 are arranged in the first direction (for example, the direction OA1).

Alternatively, as shown in FIG. 1, the first testing-unit group and the second testing-unit group are arranged in the direction perpendicular to the first direction.

In some embodiments of the present application, the circuit testing units CP pad are arranged in mirror symmetry.

In an exemplary embodiment, when the circuit testing units CP pad are arranged in mirror symmetry, their axis of symmetry (a virtual concept, which actually does not exist) extends in the first direction (for example, the direction OA1).

Accordingly, the display panel has the circuit testing units CP pad that are symmetrically arranged, which can simplify the design and reduce the difficulty in design, and can improve the aesthetics of the display panel.

In some embodiments of the present application, as shown in FIG. 1 and FIG. 2, in the direction parallel to the plane where the substrate is located, the minimum distance from the circuit testing units CP pad in the first testing-unit group T1 and the second testing-unit group T2 to the light shielding layer ZG is less than the minimum distance from bonding terminals (not shown in the figures) in the bonding sub-region B-D to the light shielding layer ZG. In this case, the dimension in the first direction (for example, the direction OA1) of the part of the light shielding layer ZG that is located on the outer side of the third lateral side L3 of the displaying region AA is less than the size in the first direction (for example, the direction OA1) of the part of the light shielding layer ZG that is located on the outer side of the fourth lateral side L4 of the displaying region AA.

It should be noted that, in the embodiments of the present application, the description related to, for example, "parallel to the plane where the substrate is located" means that, because the substrate has a low thickness, its thickness is negligible, and the three-dimensional perspective substrate is approximately deemed as a two-dimensional plane, to assist in the description. In practical applications, the substrate is not a two-dimensional plane, as explained herein. The meanings of the related descriptions in the context are similar to this, and are not discussed further.

In some embodiments of the present application, as shown in FIG. 1 to FIG. 7, the display panel includes at least one third testing-unit group T3, the third testing-unit group T3 includes a plurality of transistor testing units TEG, and the third testing-unit group T3 is located in the first peripheral sub-region B1.

The distance between the transistor testing units TEG and the light shielding layer ZG is greater than or equal to the distance between the circuit testing units CP pad and the light shielding layer ZG.

In some embodiments, as shown in FIG. 1 and FIG. 2, the distance between the transistor testing units TEG and the light shielding layer ZG is greater than the distance between the circuit testing units CP pad and the light shielding layer ZG.

In some other embodiments, the distance between the transistor testing units TEG and the light shielding layer ZG is equal to the distance between the circuit testing units CP pad and the light shielding layer ZG.

As an example, the plurality of transistor testing units TEG in one third testing-unit group T3 are divided into two parts, wherein one part is provided on the left side of the circuit testing units CP pad shown in FIG. 2, and the other part is provided on the right side of the circuit testing units CP pad shown in FIG. 2. Furthermore, all of the plurality of transistor testing units TEG in the third testing-unit group T3 are arranged in the same row as the first testing-unit group T1.

Furthermore, the plurality of transistor testing units TEG in another third testing-unit group T3 are divided into two parts, wherein one part is provided on the left side of the circuit testing units CP pad shown in FIG. 2, and the other part is provided on the right side of the circuit testing units CP pad shown in FIG. 2. Furthermore, all of the plurality of transistor testing units TEG in the third testing-unit group T3 are arranged in the same row as the second testing-unit group T2. Here, merely the positions of the provision of the circuit testing units CP pad in FIG. 2 are referred to, and the third testing-unit group T3 in FIG. 2 is not taken into consideration.

It should be noted that the transistor testing units TEG are used to test the electrical performances of the transistors in the driving circuit of the display panel, to ensure that, after the fabrication of the transistors has completed, their electric performances are stable, and if some of the transistors have electric-performance abnormality or instability, perform electrical-performance regulation or repairing to the transistors according to demands.

In some embodiments of the present application, as shown in FIG. 1 and FIG. 2, the third testing-unit group T3 is located on the side of all of the circuit testing units CP pad that is away from the displaying region AA, a gap is provided between the third testing-unit group T3 and the light shielding layer ZG, and both of the first testing-unit group T1 and the second testing-unit group T2 are located in the gap.

In some embodiments of the present application, as shown in FIG. 1, FIG. 2 and FIG. 7, the display panel includes two third testing-unit groups T3, the two third testing-unit groups T3 are arranged in the direction perpendicular to the first direction, for example, the direction OA1, the first peripheral sub-region B1 includes an encoding pattern, and the encoding pattern is located between the two third testing-unit groups T3.

The minimum distance d5 between the encoding pattern and the light shielding layer ZG is greater than or equal to the minimum distance d6 between the transistor testing units TEG and the light shielding layer ZG.

As an example, the encoding pattern, for example, an ID, is used to distinguish the different display panels produced in the same batch, and is similar to an identity identifier of the display panel. The encoding pattern may include at least one of numbers, letters, symbols and patterns.

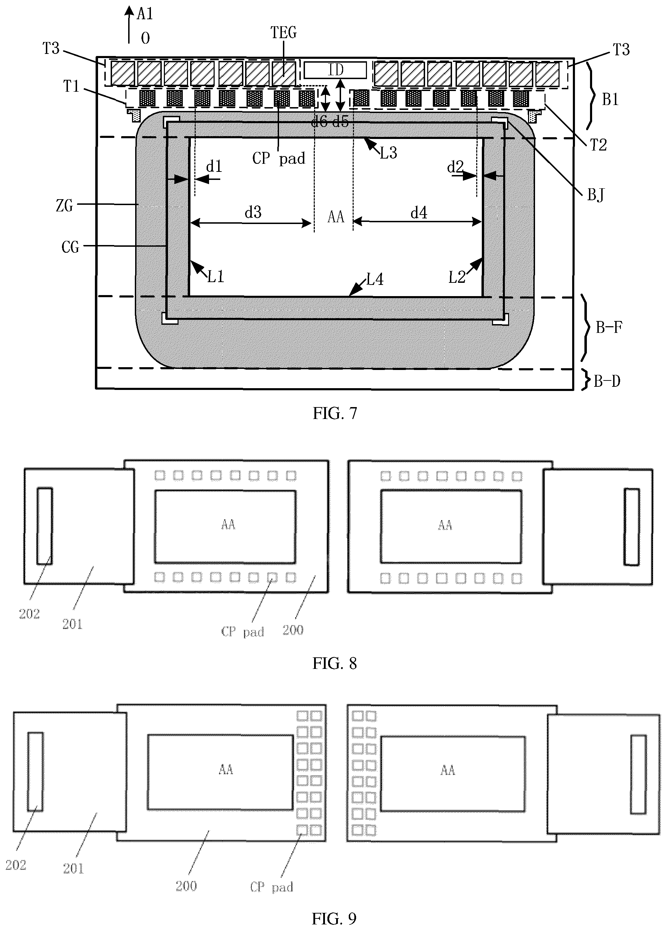

In some embodiments, as shown in FIG. 1 and FIG. 2, the minimum distance d5 between the encoding pattern and the light shielding layer ZG is greater than the minimum distance d6 between the transistor testing units TEG and the light shielding layer ZG. Because the room for marking is limited, d5 and d6 are not marked in FIG. 1 and FIG. 2, and the marking of FIG. 7 may be referred to.

In some embodiments, as shown in FIG. 7, the minimum distance d5 between the encoding pattern and the light shielding layer ZG is greater than the minimum distance d6 between the transistor testing units TEG and the light shielding layer ZG.

In the embodiments of the present application, by configuring that the minimum distance d5 between the encoding pattern and the light shielding layer ZG is greater than or equal to the minimum distance d6 between the transistor testing units TEG and the light shielding layer ZG, the encoding pattern is far from the circuit testing units CP pad to the largest extent, to, in the fabrication of the encoding pattern, prevent the laser-generated heat from adversely affecting the circuit testing units CP pad, thereby improving the stability of the circuit testing units CP pad.

In some embodiments of the present application, as shown in FIG. 1 to FIG. 7, the peripheral region further includes a second peripheral sub-region B-F, the second peripheral sub-region B-F is located between the bonding sub-region B-D and the displaying region AA, the orthographic projection of the light shielding layer ZG on the substrate falls in the region of the peripheral region other than the bonding sub-region B-D.

As shown in FIG. 6, the distance d7 in the first direction, for example, the direction OA1, between the part of the outer contour of the light shielding layer ZG that is located in the first peripheral sub-region B1 and the edge of the displaying region AA is less than the distance d8 in the first direction, for example, the direction OA1, between the part of the outer contour of the light shielding layer ZG that is located in the second peripheral sub-region B-F and the edge of the displaying region AA.

In some embodiments, the second peripheral sub-region B-F may be a fanning-out sub-region. The fanning-out sub-region is provided with fanning-out traces, and the fanning-out traces are used to electrically connect the data lines (Data) in the displaying region AA and the bonding terminals in the bonding sub-region B-D together.

In some other embodiments, the second peripheral sub-region B-F may not be provided with fanning-out traces (not a fanning-out sub-region). Instead, by using metal holes between a plurality of electrically conductive layers located in the array base plate of the display panel, for example, tungsten holes, the data lines (Data) in the displaying region AA and the bonding terminals in the bonding sub-region B-D are electrically connected together. That can further reduce the size of the peripheral region, thereby facilitating the fabrication of narrow-boundary-frame display products.

In an embodiment of the present application, the light shielding layer ZG covers the second peripheral sub-region B-F and extends to the edge of the bonding sub-region B-D, and the orthographic projection of the light shielding layer ZG on the substrate and the orthographic projection of the bonding sub-region on the substrate do not overlap with each other.

In an embodiment of the present application, if the fabrication process allows, the light shielding layer ZG covers as large area in the peripheral region other than the bonding terminals (the bonding sub-region), the circuit testing units CP pad and the transistor testing units TEG as possible, thereby reducing the reflection of light rays by the traces in the peripheral region, to improve the effect of displaying. Furthermore, because the bonding terminals (the bonding sub-region), the circuit testing units CP pad and the transistor testing units TEG are required to be electrically connected to other components in the subsequent applications, they are required to be exposed, and cannot be covered by the light shielding layer ZG.

In some embodiments of the present application, as shown in FIG. 1 to FIG. 7, the shape of the orthographic projection of the light shielding layer ZG on the substrate includes a rectangle having four rounded corners.

The curvature radius of two of the rounded corners of the rectangle that are close to the bonding sub-region B-D is greater than the curvature radius of two of the rounded corners of the rectangle that are close to the first peripheral sub-region B1.

In the embodiments of the present application, by configuring that the curvature radius of two of the rounded corners of the rectangle that are close to the bonding sub-region B-D is greater than the curvature radius of two of the rounded corners of the rectangle that are close to the first peripheral sub-region B1, the light shielding layer ZG can cover more regions in the second peripheral sub-region B-F, to shield the traces in the second peripheral sub-region B-F to the largest extent, thereby preventing the reflection of light rays by the traces, to improve the effect of displaying of the display panel.

In some embodiments of the present application, as shown in FIS. 1 to FIG. 7, the display panel includes a cover plate CG, the cover plate CG covers the displaying region AA and part of the area of the light shielding layer ZG, and the outer contour of the orthographic projection of the cover plate CG on the substrate falls in the orthographic projection of the light shielding layer ZG on the substrate.

Four vertex angles of the outer contour of the orthographic projection of the cover plate CG on the substrate are located at the four rounded corners.

It should be noted that, in the embodiments of the present application, in order to facilitate to see the other components than the cover plate CG in the display panel, in the drawings merely the outer contour of the cover plate CG is drawn.

In an exemplary embodiment, the material of the cover plate CG may be a light-transmitting material, for example, a glass or a light-transmitting resin.

In some embodiments of the present application, as shown in FIG. 1 to FIG. 7, the area of the region of the part of the light shielding layer ZG that is located in the first peripheral sub-region B1 that does not overlap with the cover plate CG is less than the area of the region of the part of the light shielding layer ZG that is located in the second peripheral sub-region B-F that does not overlap with the cover plate CG.

In an exemplary embodiment, as shown in FIG. 6, the region of the part of the light shielding layer ZG that is located in the first peripheral sub-region B1 that does not overlap with the cover plate CG may be the region marked as Areal, and the region of the part of the light shielding layer ZG that is located in the second peripheral sub-region B-F that does not overlap with the cover plate CG may be the region marked as Area2.

In some embodiments of the present application, as shown in FIG. 6, in the direction parallel to the plane where the substrate is located, the dimension d9 of the region where the cover plate CG and the light shielding layer ZG overlap in the direction from the displaying region AA pointing to the peripheral region is greater than the dimension d10 of the circuit testing units CP pad in the first direction (for example, the direction OA1).

In an exemplary embodiment, all of the dimension in the direction from the displaying region AA pointing to the peripheral region of the region where the cover plate CG and the part of the light shielding layer ZG that is located in the first peripheral sub-region B1 overlap, the dimension in the direction from the displaying region AA pointing to the peripheral region of the region where the cover plate CG and the part of the light shielding layer ZG that is located in the second peripheral sub-region B-F overlap, the dimension in the direction from the displaying region AA pointing to the peripheral region of the region where the cover plate CG and the part of the light shielding layer ZG that is located in the peripheral region and is close to the first lateral side L1 overlap, and the dimension in the direction from the displaying region AA pointing to the peripheral region of the region where the cover plate CG and the part of the light shielding layer ZG that is located in the peripheral region and is close to the second lateral side L2 overlap are equal.

In some embodiments of the present application, the area of the orthographic-projection pattern of the circuit testing units CP pad on the substrate is less than or equal to the area of the orthographic-projection pattern of the bonding terminals (not shown in the drawings) of the bonding sub-region B-D on the substrate.

In an exemplary embodiment, the dimension of the orthographic-projection pattern of the bonding terminals on the substrate in the direction from the displaying region AA pointing to the peripheral region is greater than the dimension of the orthographic-projection pattern of the circuit testing units CP pad on the substrate in the direction from the displaying region AA pointing to the peripheral region.

For example, the dimension of the orthographic-projection pattern of the bonding terminals on the substrate in the direction from the displaying region AA pointing to the peripheral region may be 5 times to 20 times the dimension of the orthographic-projection pattern of the circuit testing units CP pad on the substrate in the direction from the displaying region AA pointing to the peripheral region.

In practical applications, because, after the display panel completes the test, when the display panel is applied in the display product, and in the usage process of the user, the circuit testing units CP pad are not used, when the circuit testing units CP pad are provided, the size of the circuit testing units CP pad may be reduced to the largest extent in the permissible range of the testing process and the fabricating process, so as to reduce the room occupied by them, to increase the utilization ratio of the design room of the peripheral region, thereby facilitating the fabrication of narrow-boundary-frame display products.

In some embodiments of the present application, the quantity of the circuit testing units CP pad is greater than the quantity of the bonding terminals.

As an example, the quantity of the circuit testing units CP pad is two or more times the quantity of the bonding terminals.

In the embodiments of the present application, by configuring that the quantity of the circuit testing units CP pad is greater than the quantity of the bonding terminals, when the circuit testing units CP pad are used to detect the driving circuit in the array base plate, it can be more accurately detected whether the circuit has abnormality, or even the regions and the positions of the devices having abnormality in the driving circuit can be accurately detected, which more facilitates to repair the abnormality before the display panel is fabricated into the displaying device, thereby improving the fabrication yield and the quality of the display product.

In some embodiments of the present application, the display panel further includes a detecting unit, the detecting unit includes a plurality of auxiliary sub-pixels, and the detecting unit is located in the region of the peripheral region that is close to the first lateral side L1, and/or the detecting unit is located in the region of the peripheral region that is close to the second lateral side L2. The structure of the auxiliary sub-pixels is the same as the structure of the sub-pixels in the displaying region AA. The light shielding layer ZG covers the detecting unit.

The auxiliary sub-pixels are located in the region of the peripheral region that is close to the first lateral side L1, and/or the auxiliary sub-pixels are located in the region of the peripheral region that is close to the second lateral side L2, which includes the following cases:

Firstly, all the auxiliary sub-pixels are located in the region of the peripheral region that is close to the first lateral side L1.

Secondly, all the auxiliary sub-pixels are located in the region of the peripheral region that is close to the second lateral side L2.

Thirdly, some of the auxiliary sub-pixels are located in the region of the peripheral region that is close to the first lateral side L1, and some of the auxiliary sub-pixels are located in the region of the peripheral region that is close to the second lateral side L2.

In some embodiments, all of the emitted-light colors of the auxiliary sub-pixels may be the same. For example, all of the emitted-light colors are the white color, or all of the emitted-light colors are the blue color. In some other embodiments, the emitted-light colors of the auxiliary sub-pixels may not be completely the same. For example, the emitted-light color of some of the auxiliary sub-pixels is the red color, the emitted-light color of some of the auxiliary sub-pixels is the green color, and the emitted-light color of some of the auxiliary sub-pixels is the blue color.

In the embodiments of the present application, by providing the plurality of auxiliary sub-pixels in the peripheral region, wherein the structure of the auxiliary sub-pixels is the same as the structure of the sub-pixels in the displaying region AA, the light-emission state of the sub-pixels in the displaying region can be determined by monitoring the state of the auxiliary sub-pixels in the detecting unit. Particularly, regarding an OLED display panel, by monitoring the temperatures of the auxiliary sub-pixels in the detecting unit, the temperature difference between the auxiliary sub-pixels of different colors is determined, and because the luminous efficiency of the OLED sub-pixels is sensitive to temperature, the relevant parameters such as the driving voltage may be adjusted according to the temperature difference, thereby improving the effect of displaying of the display panel.

In some embodiments of the present application, as shown in FIG. 7, the display panel further includes four marking patterns BJ, the marking patterns BJ are located on the side of the light shielding layer ZG that is away from the substrate, and the orthographic projections of the vertex angles of the cover plate CG on the substrate and the orthographic projections of the marking patterns BJ on the substrate at least partially overlap.

It should be noted that the marking patterns BJ are used as the alignment marking for adhering the cover plate CG, to increase the alignment accuracy of the cover plate CG.

In order for distinguishing, the marking patterns BJ according to the embodiments of the present application are the alignment marking for adhering the cover plate CG, and the island-like patterns according to the embodiments of the present application are the alignment marking in the fabrication of the circuit testing units CP pad.

That the orthographic projections of the vertex angles of the cover plate CG on the substrate and the orthographic projections of the marking patterns BJ on the substrate at least partially overlap includes but is not limited to the following cases:

Firstly, the orthographic projections of the vertex angles of the cover plate CG on the substrate and the orthographic projections of the marking patterns BJ on the substrate partially overlap.

Secondly, the orthographic projections of the vertex angles of the cover plate CG on the substrate and the orthographic projections of the marking patterns BJ on the substrate completely overlap.

In the embodiments of the present application, by configuring that the orthographic projections of the vertex angles of the cover plate CG on the substrate and the orthographic projections of the marking patterns BJ on the substrate at least partially overlap, the design room of the marking patterns BJ can be saved, thereby optimizing the design of the display panel.

An embodiment of the present application provides a displaying device, wherein the displaying device includes the display panel stated above; and
the displaying device further includes a flexible circuit board FPC and a driving chip IC; or
the display panel includes a displaying controlling unit, and the displaying device further includes a flexible circuit board FPC.

In an exemplary embodiment, when the substrate of the display panel is a silicon substrate, the array base plate of the silicon substrate in the displaying device can integrate a pixel-driving-circuit array, Source Driver, Gate Driver, Emission Control Driver, OSC (oscillator), Gamma Register and a displaying-controlling-unit integrated circuit into the same chip. In this case, it is not required to provide an additional driving chip, and the display panel and the flexible circuit board FPC are directly electrically connected, which is referred to as the One Chip technique. The displaying devices fabricated by using the One Chip technique have a high integration level, and a low size, and can be suitable for high-resolution display products, for example, in the fields of Virtual Reality (referred to for short as VR) or Augmented Reality (referred to for short as AR) near-eye displaying.

In an exemplary embodiment, when the substrate of the display panel is a silicon substrate, the array base plate of the silicon substrate may also separate the analog circuit parts such as the pixel-driving-circuit array, Source driver, Gate driver and Emission driver (i.e., the EOA unit according to the present application) from OSC, Gamma register, Interface and the displaying controlling unit, whereby the One Chip technique becomes the Two Chip technique. In this case, the display panel is required to be electrically connected to the flexible circuit board FPC and the driving chip IC individually. As compared with the products of the One Chip technique, this type of products have low requirements on the fabricating process, and may employ low manufacture procedures to reduce the production cost.

The displaying device may be a flexible displaying device (also referred to as a flexible screen), and may also be a rigid displaying device (i.e., a displaying device that cannot be bent), which is not limited herein. The displaying device may be an Organic Light Emitting Diode OLED () displaying device, and may also be any products or components having a displaying function that include an OLED, such as a television set, a digital camera, a mobile phone and a tablet personal computer. The displaying device has the advantages such as a good displaying effect, a long life and a high stability.

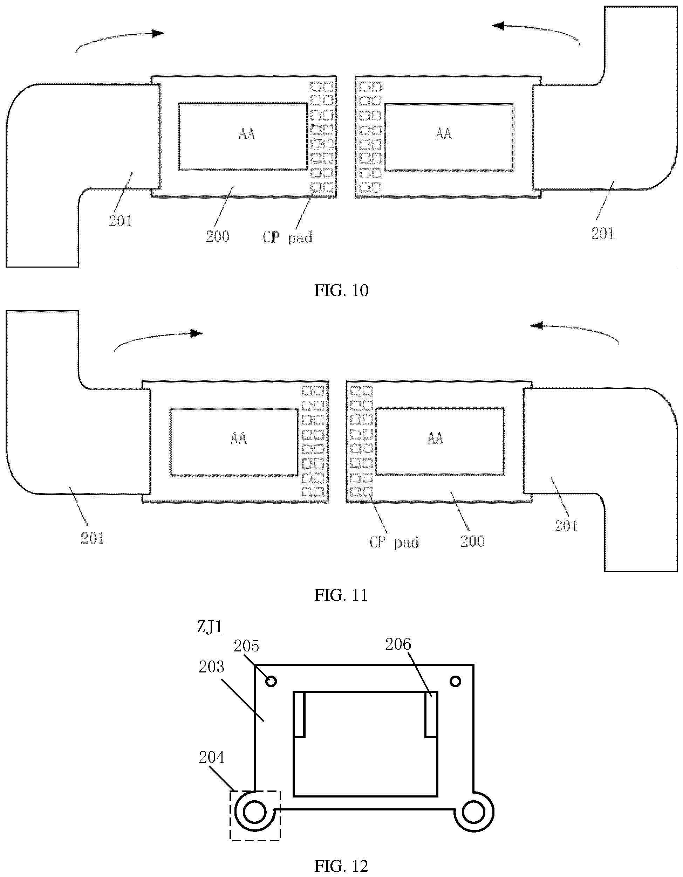

An embodiment of the present application provides a wearable device. As shown in FIG. 8 to FIG. 11, FIG. 13 and FIG. 14, the wearable device includes two displaying devices stated above, and further includes two annular first supports ZJ1 as shown in FIG. 12, the displaying devices are fixed to the first supports ZJ1, and each of the first supports ZJ1 covers the region of the peripheral region of the display panel that is not provided with the light shielding layer ZG. The circuit testing units CP pad in one of the displaying devices and the circuit testing units CP pad in the other of the displaying devices are arranged in mirror symmetry.

In an exemplary embodiment, because the bonding terminals (the bonding sub-region B-D), the circuit testing units CP pad and the transistor testing units TEG are required to be electrically connected to other components in the subsequent processes after the fabrication of the display panels has completed, so as to perform the performance test on the circuits or the transistors, they are required to be exposed, and cannot be covered by the light shielding layer ZG. When the display panels are fabricated into the displaying devices (at which point the bonding terminals have already been provided with the flexible circuit boards and are not exposed), the performance test on the circuits or the transistors has already been completed, but those exposed circuit testing units CP pad and transistor testing units TEG reflect light rays, which deteriorates the effect of displaying, and deteriorates the usage experience of the user. Therefore, in the installation of the first supports ZJ1, the first supports ZJ1 are caused to shield the exposed circuit testing units CP pad and transistor testing units TEG, thereby preventing light reflection, improve the effect of displaying and the usage experience of the user.

In some embodiments of the present application, in order to improve the effect of the shielding, and prevent the first support ZJ1 and the light shielding layer ZG from leaving a gap therebetween to result in light reflection, it is configured that the orthographic projection of the first support ZJ1 on the substrate of the display panel intersects or overlaps with the orthographic projection of the light shielding layer ZG on the substrate. Accordingly, the exposed circuit testing units CP pad and transistor testing units TEG can be further shielded, thereby preventing light reflection, improve the effect of displaying and the usage experience of the user.

Furthermore, by configuring that the circuit testing units CP pad in one of the displaying devices and the circuit testing units CP pad in the other of the displaying devices are arranged in mirror symmetry, the displaying regions of the two displaying devices can be arranged symmetrically to the largest extent, which can ameliorate the problem to a certain extent that the unequal heights of the center points of the view fields of the left and right eyes of the wearable device cause ghosting of the frames observed by the user, thereby improving the usage experience of the user.

In some embodiments of the present application, it may also be configured that the circuit testing units CP pad in one of the displaying devices and the circuit testing units CP pad in the other of the displaying devices are arranged in mirror symmetry, and the displaying region in one of the displaying devices and the displaying region in the other of the displaying devices are arranged in mirror symmetry, which can prevent the problem that the unequal heights of the center points of the view fields of the left and right eyes of the wearable device cause ghosting of the frames observed by the user, thereby improving the usage experience of the user.

In some embodiments of the present application, the inner contour of the orthographic projection of the first support ZJ1 on the substrate is at least partially connected to the outer contour of the orthographic projection of the cover plate CG on the substrate. Accordingly, at least part of the outer edge of the cover plate CG is snap-fitted to the inner contour of the first support ZJ1, thereby serving to fix.

In some embodiments, as shown in FIG. 12, each of the first supports ZJ1 further includes blocking parts 206. The blocking parts 206 contact the back face of the displaying device, to prevent the displaying devices of the wearable device from moving or loosening in the direction perpendicular to the plane where the substrate is located.

The back face refers to the face opposite to the light-exiting face.

In some embodiments, as shown in FIG. 12, each of the first supports ZJ1 further includes two first mounting members 204 and two second mounting members 205.

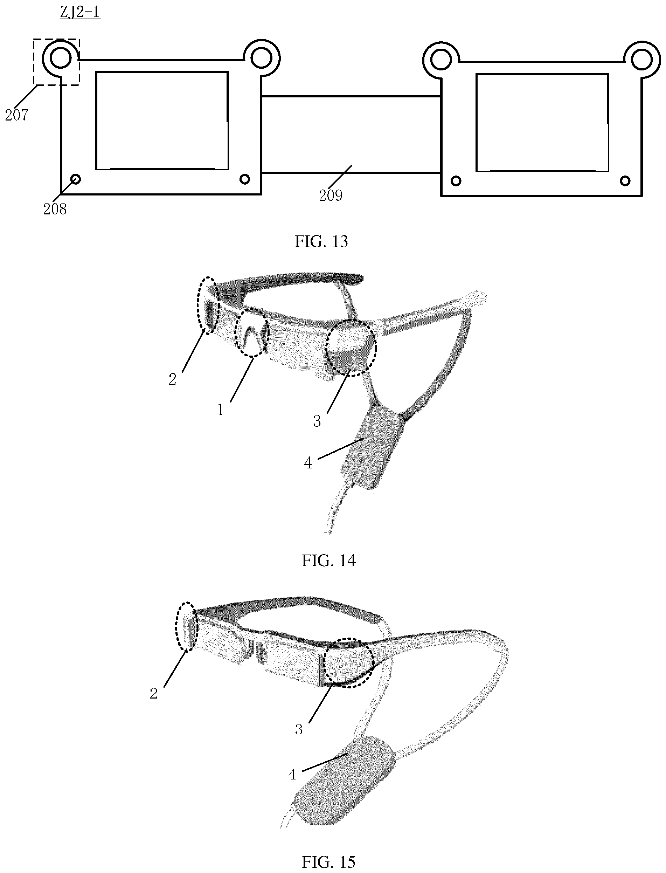

In some embodiments of the present application, the wearable device further includes a second support, and the second support is configured to be wearable. If the wearable device is glasses, the second support includes a main-body part ZJ2-1 and two eyeglass temples connected to the main-body part ZJ2-1, as shown in FIG. 13. A driving board and the two first supports ZJ1 are fixed to the main-body part ZJ2-1 of the second support, and the driving board is electrically connected to the flexible circuit boards FPC of the two displaying devices.

The main-body part ZJ2-1 of the second support shown in FIG. 13 includes a connector 209, two third mounting members 207 and two fourth mounting members 208. The second mounting members 205 of the first support ZI1 are mounted and fixed to the third mounting members 207 of the second support, and the first mounting members 204 of the first support ZI1 are mounted and fixed to the fourth mounting members 208 of the second support.

The driving board is used to provide information such as an image signal to the displaying devices.

The particular structures of the mounting members are not limited herein. As an example, all of the first mounting members 204 and the third mounting members 207 shown in FIG. 12 and FIG. 13 may be of an annular structure, and all of the second mounting members 205 and the fourth mounting members 208 shown in FIG. 12 and FIG. 13 may be of a columnar structure.

In some embodiments, as shown in FIG. 8 to FIG. 11, the two display panels are arranged in mirror symmetry, and the geometric centers of the displaying regions AA of the two display panels and the geometric center of the main-body part ZJ2-1 of the second support are located in the same straight line. It should be noted that the display panels are referred to as the displaying devices after bonded to the flexible circuit boards 201.

The shape and the size of the flexible circuit board 201 are not limited herein, and may be decided particularly according to practical designs. As an example, the shape of the flexible circuit board 201 may be a rectangle or an L shape.

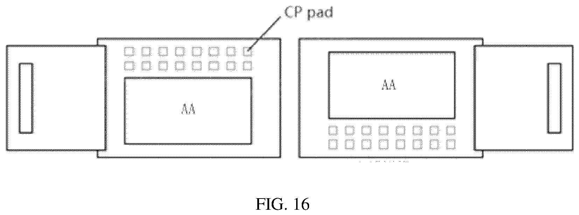

In the embodiments of the present application, by configuring that the two display panels of the wearable device are arranged in mirror symmetry, and the geometric centers of the displaying regions AA of the two display panels and the geometric center of the main-body part ZJ2-1 of the second support are located in the same straight line, when the user is using the device, the center of the view field of the left eye of the user and the center of the view field of the right eye of the user are located in the same straight line, which, as compared with the device in the related art shown in FIG. 16, can significantly prevent the problem that the unequal heights of the center points of the view fields of the left and right eyes cause ghosting observed by the user, thereby improving the usage experience of the user.

In some embodiments, as shown in FIG. 8 and FIG. 9, the two displaying devices are arranged in mirror symmetry, wherein each of the displaying devices includes the display panel and the flexible circuit board 201.

In an exemplary embodiment, the flexible circuit board 201 is provided with a connecting interface 202 (also referred to as a connector), and the connecting interface is used to electrically connect to an external circuit.

In some embodiments, as shown in FIG. 10 and FIG. 11, the two flexible circuit boards 201 are arranged in centrosymmetry with the geometric center of the main-body part of the second support as the symmetry point.

It should be noted that all of FIG. 8 to FIG. 11 are schematic diagrams of the intermediate structures of the wearable device.

FIG. 14 and FIG. 15 show two schematic structural diagrams of the wearable device. The wearable device further includes a driving board. The driving board may be provided at the position of the mark 1, the mark 2 or the mark 3. The driving board is electrically connected to the two flexible circuit boards 201.

As an example, the driving board is provided at the position of the mark 1 of the wearable device, to maintain the balance of the device. In this case, the two flexible circuit boards 201 may be bent in the directions marked by the arrows shown in FIG. 10 or FIG. 11, and be electrically connected to the driving board provided at the position of the mark 1. In this case, the two flexible circuit boards 201 are arranged in centrosymmetry with the geometric center of the second support as the symmetry point.

In an exemplary embodiment, the wearable device further includes a first lens and a second lens provided on the light exiting sides of the displaying devices. The contents relevant to the first lens and the second lens may refer to the related art, and are not discussed further herein.

It should be noted that, regarding the wearable device shown in FIG. 14 and FIG. 15, both of the light exiting sides of the two displaying devices face the positions of the human eyes. Furthermore, two traces electrically connected to the two flexible circuit boards are provided at the positions of the eyeglass temples of the wearable device shown in FIG. 14 and FIG. 15. The component 4 is used to connect the two traces in parallel, and electrically connect to an external device. The external device is used to supply a controlling signal to the wearable device.

The above are merely particular embodiments of the present application, and the protection scope of the present application is not limited thereto. All of the variations or substitutions that a person skilled in the art can easily envisage in the technical scope disclosed by the present application should fall in the protection scope of the present application. Therefore, the protection scope of the present application should be subject to the protection scope of the claims.

## Claims

1. A display panel, **characterized in that** the display panel comprises a displaying region and a peripheral region surrounding the displaying region, and the peripheral region comprises a bonding sub-region located on one side of the displaying region;
a region of the peripheral region other than the bonding sub-region comprises a first testing-unit group and a second testing-unit group, and each of the first testing-unit group and the second testing-unit group comprises one or more circuit testing units;
the displaying region comprises a first lateral side and a second lateral side that extend in a first direction and face each other, wherein the first direction refers to a direction from the bonding sub-region pointing to the displaying region; and
a maximum distance from the first testing-unit group to the first lateral side in a direction perpendicular to the first direction is equal to a maximum distance from the second testing-unit group to the second lateral side in the direction perpendicular to the first direction.

2. The display panel according to claim 1, **characterized in that** a minimum distance from the first testing-unit group to the first lateral side in the direction perpendicular to the first direction is equal to a minimum distance from the second testing-unit group to the second lateral side in the direction perpendicular to the first direction.

3. The display panel according to claim 2, **characterized in that** the region of the peripheral region other than the bonding sub-region comprises a light shielding layer;
an inner contour of an orthographic projection of the light shielding layer on a substrate of the display panel contacts an edge of the displaying region; and
both of the first testing-unit group and the second testing-unit group are located on one side of the light shielding layer that is away from the displaying region, and orthographic projections of the first testing-unit group and the second testing-unit group on the substrate do not overlap with the orthographic projection of the light shielding layer on the substrate.

4. The display panel according to claim 3, **characterized in that** the peripheral region comprises a first peripheral sub-region, and the first peripheral sub-region is located on one side of the displaying region that is away from the bonding sub-region;
some of the circuit testing units in the first testing-unit group are located in the first peripheral sub-region, and the other of the circuit testing units in the first testing-unit group are located in a region of the peripheral region that is close to the first lateral side; and
some of the circuit testing units in the second testing-unit group are located in the first peripheral sub-region, and the other of the circuit testing units in the second testing-unit group are located in a region of the peripheral region that is close to the second lateral side.

5. The display panel according to claim 4, **characterized in that** connecting lines between geometric centers of the circuit testing units in the first testing-unit group and connecting lines between geometric centers of the circuit testing units in the second testing-unit group individually form two intersecting line segments; or
the connecting lines between the geometric centers of the circuit testing units in the first testing-unit group and the connecting lines between the geometric centers of the circuit testing units in the second testing-unit group are arc lines.

6. The display panel according to claim 3, **characterized in that** geometric centers of the circuit testing units in the first testing-unit group are located in a same line segment, and geometric centers of the circuit testing units in the second testing-unit group are located in a same line segment.

7. The display panel according to claim 6, **characterized in that** all of the circuit testing units in the first testing-unit group are located in a region of the peripheral region that is close to the first lateral side, and all of the circuit testing units in the second testing-unit group are located in a region of the peripheral region that is close to the second lateral side.

8. The display panel according to claim 7, **characterized in that** each of the first testing-unit group and the second testing-unit group comprises a first end close to the bonding sub-region and a second end away from the bonding sub-region; and
a minimum distance between the first end and the displaying region in the direction perpendicular to the first direction is greater than or equal to a minimum distance between the second end and the displaying region in the direction perpendicular to the first direction.

9. The display panel according to claim 6, **characterized in that** all of the circuit testing units in the first testing-unit group and the second testing-unit group are located in the first peripheral sub-region, and the circuit testing units in a same group are arranged in the direction perpendicular to the first direction; and
the first testing-unit group and the second testing-unit group are arranged in the first direction; or
the first testing-unit group and the second testing-unit group are arranged in the direction perpendicular to the first direction.

10. The display panel according to any one of claims 4-9, **characterized in that** the circuit testing units are arranged in mirror symmetry.

11. The display panel according to claim 9, **characterized in that** in a direction parallel to a plane where the substrate is located, a minimum distance from the circuit testing units in the first testing-unit group and the second testing-unit group to the light shielding layer is less than a minimum distance from bonding terminals in the bonding sub-region to the light shielding layer.

12. The display panel according to claim 9, **characterized in that** the display panel comprises at least one third testing-unit group, the third testing-unit group comprises a plurality of transistor testing units, and the third testing-unit group is located in the first peripheral sub-region; and
a distance between the transistor testing units and the light shielding layer is greater than or equal to a distance between the circuit testing units and the light shielding layer.

13. The display panel according to claim 12, **characterized in that** the third testing-unit group is located on one side of all of the circuit testing units that is away from the displaying region, a gap is provided between the third testing-unit group and the light shielding layer, and both of the first testing-unit group and the second testing-unit group are located in the gap.

14. The display panel according to claim 13, **characterized in that** the display panel comprises two third testing-unit group, the two third testing-unit groups are arranged in the direction perpendicular to the first direction, the first peripheral sub-region comprises an encoding pattern, and the encoding pattern is located between the two third testing-unit groups; and
a minimum distance between the encoding pattern and the light shielding layer is greater than or equal to a minimum distance between the transistor testing units and the light shielding layer.

15. The display panel according to claim 10, **characterized in that** the peripheral region further comprises a second peripheral sub-region, the second peripheral sub-region is located between the bonding sub-region and the displaying region, and the orthographic projection of the light shielding layer on the substrate falls within the region of the peripheral region other than the bonding sub-region; and
a distance in the first direction between a part of an outer contour of the light shielding layer that is located in the first peripheral sub-region and the edge of the displaying region is less than a distance in the first direction between a part of the outer contour of the light shielding layer that is located in the second peripheral sub-region and the edge of the displaying region.

16. The display panel according to claim 15, **characterized in that** a shape of the orthographic projection of the light shielding layer on the substrate comprises a rectangle having four rounded corners; and
a curvature radius of two of the rounded corners of the rectangle that are close to the bonding sub-region is greater than a curvature radius of two of the rounded corners of the rectangle that are close to the first peripheral sub-region.

17. The display panel according to claim 16, **characterized in that** the display panel comprises a cover plate, the cover plate covers the displaying region and part of the area of the light shielding layer, and an outer contour of an orthographic projection of the cover plate on the substrate falls within the orthographic projection of the light shielding layer on the substrate; and
four vertex angles of the outer contour of the orthographic projection of the cover plate on the substrate are located at the four rounded corners.

18. The display panel according to claim 17, **characterized in that** an area of a region of a part of the light shielding layer that is located in the first peripheral sub-region that does not overlap with the cover plate is less than an area of a region of a part of the light shielding layer that is located in the second peripheral sub-region that does not overlap with the cover plate.

19. The display panel according to claim 17, **characterized in that** in a direction parallel to a plane where the substrate is located, a dimension of a region where the cover plate and the light shielding layer overlap in a direction from the displaying region pointing to the peripheral region is greater than a dimension of the circuit testing units in the first direction.

20. The display panel according to claim 11, **characterized in that** an area of an orthographic-projection pattern of the circuit testing units on the substrate is less than or equal to an area of an orthographic-projection pattern of the bonding terminals on the substrate.

21. The display panel according to claim 20, **characterized in that** a quantity of the circuit testing units is greater than a quantity of the bonding terminals.

22. The display panel according to any one of claims 11-21, **characterized in that** the display panel further comprises a detecting unit, the detecting unit comprises a plurality of auxiliary sub-pixels, and the auxiliary sub-pixels are located in a region of the peripheral region that is close to the first lateral side, and/or the auxiliary sub-pixels are located in a region of the peripheral region that is close to the second lateral side;
a structure of the auxiliary sub-pixels is the same as a structure of the sub-pixels in the displaying region; and
the light shielding layer covers the detecting unit.

23. The display panel according to claim 22, **characterized in that** the display panel further comprises four marking patterns, the marking patterns are located on one side of the light shielding layer that is away from the substrate, and orthographic projections of the vertex angles of the cover plate on the substrate and orthographic projections of the marking patterns on the substrate at least partially overlap.

24. A displaying device, **characterized in that** the displaying device comprises the display panel according to any one of claims 1-23; and
the displaying device further comprises a flexible circuit board and a driving chip; or
the display panel comprises a displaying controlling unit, and the displaying device further comprises a flexible circuit board.

25. A wearable device, **characterized in that** the wearable device comprises two instances of the displaying device according to claim 24, and further comprises two annular first supports, the displaying devices are fixed to the first supports, and each of the first supports covers a region of the peripheral region of the display panel that is not provided with the light shielding layer; and
the circuit testing units in one of the displaying devices and the circuit testing units in the other of the displaying devices are arranged in mirror symmetry.

26. The wearable device according to claim 25, **characterized in that** an orthographic projection of the first support on the substrate of the display panel overlaps with an orthographic projection of the light shielding layer on the substrate.

27. The wearable device according to claim 26, **characterized in that** an inner contour of the orthographic projection of the first support on the substrate is at least partially connected to an outer contour of an orthographic projection of the cover plate on the substrate.

28. The wearable device according to claim 27, **characterized in that** the wearable device further comprises a second support, the second support is configured to be wearable, the second support comprises a main-body part and two eyeglass temples, a driving board and the two first supports are fixed to the main-body part of the second support, and the driving board is electrically connected to the flexible circuit boards of the two displaying devices; and
the two display panels are arranged in mirror symmetry, geometric centers of the displaying regions of the two display panels and a geometric center of the main-body part of the second support are located in a same straight line, and the two flexible circuit boards are arranged in centrosymmetry with the geometric center of the second support as a symmetry point.
